# EUROPEAN PATENT SPECIFICATION

(11) **EP 3 244 442 B1**
(45) Date of publication and mention of the grant of the patent: **03.08.2022**
(21) Application number: 16168722.3
(22) Date of filing: 09.05.2016
(51) Int. Cl.: H01L 21/208, H01L 21/368

(54) **A METHOD OF FORMING A DEVICE COMPRISING QUANTUM DOTS**
VERFAHREN ZUR HERSTELLUNG EINER VORRICHTUNG MIT QUANTENPUNKTEN
PROCÉDÉ DE FORMATION D'UN APPAREIL COMPRENANT DES POINTS QUANTIQUES

(43) Date of publication of application: 15.11.2017
(73) Proprietor: Emberion Oy, 02130 Espoo (FI)
(72) Inventor: Bessonov, Alexander, Cambridge, Cambridgeshire CB1 3HR (GB); Bower, Chris, Ely, Cambridgeshire CB6 3EN (GB); White, Richard, Huntingdon, Cambridgeshire PE28 9DY (GB); Medina-Salazar, Ivonne, Cambridge, Cambridgeshire CB4 3HX (GB); Ryhanen, Tapani, 00200 Helsinki (FI)
(74) Representative: Boco IP Oy Ab

(56) References cited:
- WO-A1-2012/138410
- US-A1- 2009 280 586
- US-B2- 9 034 669

## Description

### TECHNOLOGICAL FIELD

Examples of the disclosure relate to a method of forming an apparatus comprising quantum dots. In particular, they relate to a method of forming an apparatus comprising quantum dots where the quantum dots are connected to one or more electrical components.

### BACKGROUND

Apparatus such as sensing devices which comprise quantum dots are known. Such apparatus may be configured to provide optoelectronic device such as photodetectors, light emitting devices or other types of optoelectronic devices.

It is useful to improve such apparatus and the methods of fabricating such apparatus.

### BRIEF SUMMARY

The present invention is defined in the appended claims.

### BRIEF DESCRIPTION

For a better understanding of various examples that are useful for understanding the detailed description, reference will now be made by way of example only to the accompanying drawings in which:
Fig. 1 illustrates a method;
Fig. 2 illustrates a method;
Fig. 3 illustrates a method;
Fig. 4 illustrates a method;
Fig. 5 illustrates an apparatus; and
Figs. 6A and 6B illustrate an example apparatus.

### DETAILED DESCRIPTION

The Figures illustrate a method comprising: depositing 11 a quantum dot solution 23 onto a first substrate 21; solidifying 13 the quantum dot solution 23 on the first substrate 21 to form a solid layer 25 of quantum dots; arranging 15 the first substrate 21 overlaying a second substrate 27 so that an electrical connection is established between the solid layer 25 of quantum dots and one or more electrical components on the second substrate 27.

The method is for forming an apparatus 1 comprising quantum dots. The quantum dots may provide an optoelectronic layer within the apparatus 1. The quantum dots may be configured to provide an electronic response in response to incident light. Such apparatus 1 could comprise photodetectors such as quantum dot-graphene field effect transistors, light-emitting devices such as quantum dot light emitting diodes or photovoltaic devices such as quantum dot solar cells or any other suitable apparatus 1.

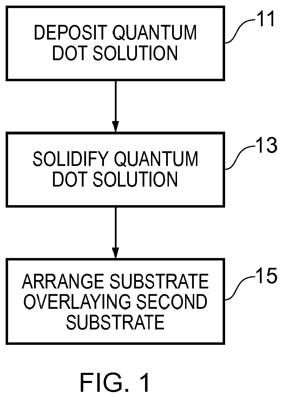

Fig. 1 schematically illustrates a method according to examples of the disclosure. The method is used to form an apparatus 1 comprising quantum dots.

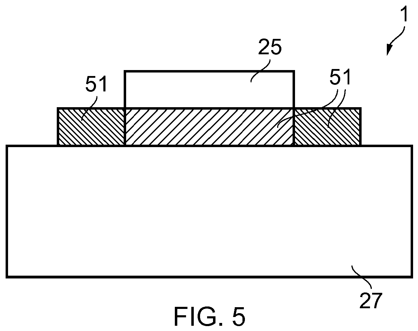

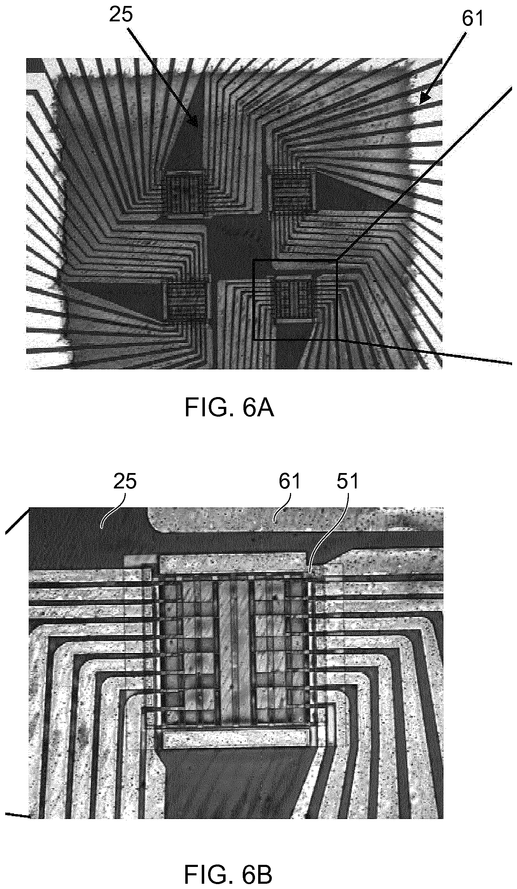

Examples of apparatus 1 that may be formed are illustrated in Figs. 5 and 6A and 6B.

The method comprises, at block 11, depositing a quantum dot solution 23 onto a first substrate 21.

The first substrate 21 may be any suitable substrate 21 which comprises a surface onto which the quantum dot solution 21 can be deposited. In some examples the first substrate 21 may comprise an elastomeric material. The use of an elastomeric material may make it easier to transfer the quantum dots to a second substrate 27.

In some examples the first substrate 21 may comprise a material with a low surface energy. This may facilitate the transfer of the quantum dots from the first substrate 21 to a second substrate 27.

In some examples the first substrate may comprise a silicone based elastomer such as polydimethylsiloxane (PDMS), or other materials such as, but not limited to, polyurethane, parylene fluorinated or perfluorinated elastomers, neoprene, ethylene acrylic elastomers.

The first substrate 21 may have any suitable thickness. The thickness of the first substrate 21 may depend on whether or not the first substrate 21 is to form part of the apparatus 1. In some examples the first substrate 21 may have a thickness in the range of 50µm to 10mm. Other thicknesses may be used in other examples of the disclosure.

The quantum dot solution 23 may comprise any suitable type of quantum dot solution. The quantum dot solution 23 may comprise quantum dots connected to a long chain ligand. The long chain ligand may be selected to enable the quantum dots to be dissolved in the solution and prevent the quantum dots from precipitating out of the solution. The ligand that is used may depend upon the material that is used for the quantum dots, the solvent that is used and any other suitable factor.

The quantum dots may comprise semiconductor nanocrystals in which there is quantum confinement in all three dimensions. The quantum dots may be colloidal quantum dots. The quantum dots may be any suitable size and/or shape. In some examples the quantum dots may be between 2 to 50nm.

The quantum dots may comprise any suitable semiconductor material. The semiconductor material that is used for the quantum dots may be chosen to enable the quantum dots to be used to provide an optoelectronics apparatus. The quantum dots may be selected to provide an electrical output in response to incident light and/or to provide light in response to an electrical input. The material that is used for the quantum dots could comprise any one or more of PbS, PbSe, PbTe, CdS, CdSe, ZnO, ZnS, CZTS, Cu₂S, Bi₂S₃, Ag₂S, HgTe, CdHgTe, InAs, InSb, Ge, or any other suitable material. The quantum dots may be combined with other light sensitive materials such as Perovskites based upon methylammonium tin or lead halides for example CH3NH3PbX3 or CH3NH3SnX3.

The quantum dot solution 23 may be deposited onto the first substrate 21 in a desired pattern. The pattern may correspond to the arrangement of the electrical components on a second substrate 27. The pattern may be configured to enable the quantum dots to be aligned with electrical components or parts of electrical components on the second substrate 27. The alignment between the quantum dots and the electrical components or parts of electrical components may enable an electrical connection to be established between the quantum dots and the electrical components.

The quantum dot solution 23 may be deposited on to the first substrate 21 in a desired thickness. The thickness of the quantum dot solution 23 may be selected to optimise the thickness of the solid layer 25 of quantum dots that is to be formed from the quantum dot solution 23. The thickness of the solid layer 25 of quantum dots may be configured to optimise the responsivity of the solid layer 25 of quantum dots to incident light and/or electrical inputs.

Any suitable process may be used to deposit the quantum dot solution 23 onto the first substrate 21. The deposition process may be an additive deposition process. In some examples the quantum dot solution 23 may be deposited by a non-contact printing method such as inkjet printing, aerosol jetting, microdispensing or any other suitable process. In some examples a patterning process may be used. The patterning process may comprise etching a pattern onto the surface of the first substrate 21 and then depositing the quantum dot solution 23 on to the etched pattern. Other processes may be used in other examples of the disclosure.

In some examples the surface of the first substrate 21 may be treated before the quantum dot solution 23 is deposited. The surface may be treated to improve the adhesion of the quantum dot solution 23 onto the surface of the first substrate 21. The treatment of the surface of the first substrate 21 may improve the wettability of the surface of the first substrate 21. The treatment could comprise any suitable treatment such as O₂ plasma treatment, ultra violet/ozone treatment (UVO), corona discharge treatment (CDT), or by coating the surface of the first substrate 21 with a suitable material such as parylene or by any other suitable process.

At block 13 the method comprises solidifying the quantum dot solution 23 on the first substrate 21 to form a solid layer 25 of quantum dots.

In some examples the process of solidifying the quantum dot solution 23 may comprise a ligand exchange process in which the long chain ligand is exchanged for a short chain ligand.

The short chain ligand may be configured to connect the quantum dots to each other in a solid layer. The short chain ligands may also be configured to enable the quantum dots to be electrically connected to components on another substrate. For example the short chain ligands may be configured to enable the quantum dots to be electrically connected to graphene or any other suitable components. The short chain ligands may enable efficient charge transfer between the quantum dots and the electrical components.

In some examples of the disclosure the solid layer 25 of quantum dots may comprise more than one ligand. For instance the solid layer 25 could comprise a combination of two or more ligands. In other examples the quantum dots may be charge stabilised using charged groups such as sulphides, sulphates, halide ions or other charged moieties. The quantum dots may be combined with other light sensitive materials such as perovskites based upon methylammonium tin or lead halides for example CH3NH3PbX3 or CH3NH3SnX3 to provide stabilisation and improved charge extraction.

The material that is used for the short chain ligand could comprise Ethanedithiol, pyridine, ethylene diamine, ethanethiol, propanethiol, benzenedithiol, hydrazine, formic acid, oxalic acid, acetic acid, or inorganic moieties such as SnS₄, PbBr₂, Pbl₂, PbCl₂, S²⁻, I⁻, Br⁻, Cl⁻, SO₄²⁻, or any other suitable material.

In other examples the process of solidifying the quantum dot solution 23 may comprise removing the ligands. In such examples a second ligand need not be provided to replace the long chain ligand from the solution 23.

In some examples the process of solidifying the quantum dot solution 23 may comprise curing the quantum dot solution 23 by exposing the quantum solution to UV (ultraviolet) radiation or any other suitable process.

At block 15 the method comprises arranging the first substrate 21 overlaying a second substrate 27.

The second substrate 27 may be any suitable substrate 27 which comprises a surface onto which the solid layer 25 of quantum dots can be transferred. The second substrate 27 is a silicon substrate.

The second substrate 27 may have any suitable thickness. In some examples the second substrate 27 may have a thickness in the range of 50µm to 10mm. Other thicknesses may be used in other examples of the disclosure.

The second substrate 27 comprises one or more electrical components. The one or more electrical components may be provided on a surface of the second substrate 27. The electrical components could be components of optoelectronic devices. The electrical components may be arranged so that the solid layer 25 of quantum dots provides an optoelectronic layer within the optoelectronic devices.

In some examples the electrical components may comprise two dimensional materials such as graphene. For instance the electrical components may be arranged to form a graphene field effect transistor or any other suitable type of device. In such examples the two dimensional material may be configured so that the solid layer 25 of quantum dots can be electrically connected to the two dimensional material. This may enable charge transfer between the solid layer 25 of quantum dots and the layer of two dimensional material.

The first substrate 21 is arranged overlaying the second substrate 27 so that an electrical connection is established between the solid layer 25 of quantum dots and one or more electrical components on the second substrate 27.

The first substrate 21 is left overlaying the second substrate 27 so that the first substrate 21 also forms part of the apparatus 1. The first substrate 21 provides an encapsulation layer which may be configured to protect the solid layer 25 of quantum dots. In such examples the encapsulation layer may be configured to provide at least one of mechanical protection, chemical protection, oxygen protection, moisture protection or any other suitable type of protection. In such examples the method may be performed in an inert atmosphere to avoid the inclusion of contaminants such as oxygen or moisture. Any suitable gases such as nitrogen and argon may be used to provide the inert atmosphere within a glove box or any other suitable apparatus.

In examples where the first substrate 21 forms part of the apparatus 1 the first substrate 21 may be at least partially transparent to light. The first substrate 21 may be at least partially transparent to light of certain wavelengths. In some examples the wavelengths could be between 500-2000nm or any other suitable range. This may enable the incident light to be detected by the solid layer 25 of quantum dots and/or may enable light generated by the quantum dots to be emitted.

In some examples the first substrate 21 may comprise one or more optical components which may be configured to increase the efficiency of an optoelectronic device. For instance, in some examples the first substrate 21 may comprise one or more optical components which may be configured to direct incident light onto the solid layer 25 of quantum dots or improve the efficiency of light collection by focussing light onto the active regions of a photodetector element or array. Such optical components could comprise one or more lenses, a micro lens array, a light guide or any other suitable component. In some examples the optical components could comprise an antireflective coating which could be configured to reduce the amount of incident light that is reflected before it reaches the solid layer 25 of quantum dots. This may further increase the efficiency of the apparatus 1.

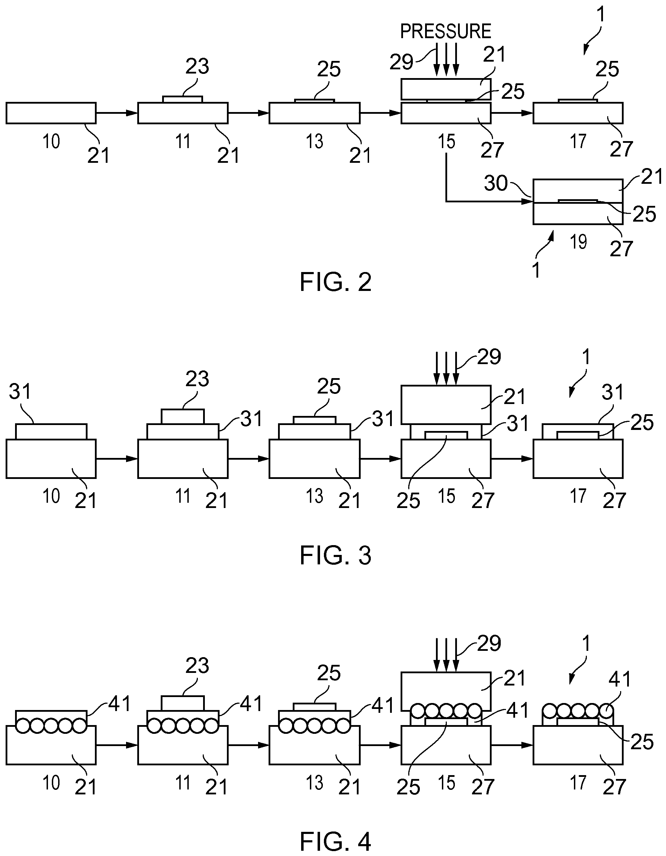

Fig. 2 schematically illustrates an example method in more detail. Corresponding reference numerals are used for corresponding features.

At block 10 a first substrate 21 is provided. The first substrate 21 may be any suitable substrate as described above. The first substrate 21 may be treated before the quantum dot solution 23 is deposited.

In the example of Fig. 2 the first substrate 21 has a flat or substantially flat surface onto which the quantum solution 23 is deposited. In other examples a patterned or multistep surface could be provided. The topology of the surface of the first substrate 21 may be arranged to correspond with the surface and/or electrical components on the second substrate 27. This may enable the quantum dots to be aligned with the electrical components on the second substrate 27.

At block 11 the quantum dot solution 23 is deposited on to the first substrate 21. The quantum dot solution 23 may be deposited in any suitable pattern and using any suitable processes.

At block 13 the quantum dot solution 23 is solidified to form the solid layer 25 of quantum dots. The solid layer 25 of quantum dots is formed on the first substrate 21 so that only the first substrate 21 is exposed to the chemicals and other parameters that are used to solidify the quantum dot solution 23 such as the ligand replacement or the combination with perovskite material. The solid layer 25 of quantum dots may be formed in a pattern corresponding to the pattern in which the quantum dot solution 23 is deposited.

The solid layer 25 of quantum dots may form a compact layer. The solid layer 25 of quantum dots 25 may be thinner than the layer of quantum dot solution 23 that was originally deposited.

At block 15 the first substrate 21 is provided overlaying a second substrate 27. The first substrate 21 may be provided overlaying the second substrate 27 so that the solid layer 25 of quantum dots is aligned with one or more of the electrical components on the second substrate 27.

In some examples pressure may be applied to the first substrate 21 as indicated by the arrows 29 to ensure that an electrical connection is made between the solid layer 25 of quantum dots and the electrical components on the second substrate 27. The pressure may enable the solid layer 25 of quantum dots to be transferred from the first substrate 21 to the second substrate 27.

The first substrate 21 is left on the second substrate 27. In such examples the second substrate 27 may be bonded or adhered to the first substrate 21. In such examples the apparatus first substrate 21 forms part of the apparatus 1.

In the example of Fig. 2 the first substrate 21 provides an encapsulation layer 30. The encapsulation layer 30 may be configured to protect the solid layer 25 of quantum dots and/or the electrical components. In some examples the encapsulation layer 30 may be configured to provide mechanical protection for the solid layer 25 of quantum dots and/or the electrical components. For instance it may protect them from being scratched or otherwise damaged. In some examples the encapsulation layer 30 may be configured to protect the solid layer 25 of quantum dots and/or the electrical components from contaminants such as water, oxygen and any other containments.

In some examples the encapsulation layer 30 may be at least partially transparent. The encapsulation layer 30 may be at least partially transparent to enable light incident on apparatus 1 to pass through the encapsulation layer 30 to the solid layer 25 of quantum dots. In some examples the encapsulation layer 30 may be at least partially transparent to enable light generated by the solid layer 25 of quantum dots to reach be emitted by the apparatus 1.

The encapsulation layer 30 may be transparent to a range of wavelengths of light but may be opaque to other wavelengths of light. This may enable the encapsulation layer 30 to act as a filter. For example the encapsulation layer 30 may be transparent or at least partially transparent to light within the visible range but may be opaque to UV light. This may protect the electronic components and the solid layer 25 of quantum dots from UV light.

Fig. 3 schematically illustrates another example method in more detail. Corresponding reference numerals are used for corresponding features.

In the example method of Fig. 3 a first substrate 21 is provided at block 10. The first substrate 21 comprises a layer of scintillator material 31.

The scintillator material 31 may comprise any material which may convert incident electromagnetic radiation of a first wavelength into electromagnetic radiation of a different wavelength. In some examples the scintillator material 31 may be configured to convert incident x-rays into light in the visible range.

The scintillator material 31 may comprise any suitable materials such as as thalium doped Csl, Nal:TI, Csl:Na, LaBr3:Ce, Gd2O2S, Bi4Ge3O12, organosilicon luminophores, crystalline perovskites or any other suitable material.

In the example of Fig. 3 the scintillator material 31 is provided on a surface of the first substrate 21. At block 11 the quantum dot solution 23 is deposited on to the first substrate 21. In the example of Fig. 3 the quantum dot solution is deposited onto the scintillator material 31. In some examples a coating may be provided on the scintillator material 31. The coating may comprise any materials which may aid adhesion and/or spreading of the quantum dot solution 23.

The quantum dot solution 23 may be deposited in any suitable pattern and using any suitable processes.

At block 13 the quantum dot solution 23 is solidified to form the solid layer 25 of quantum dots. The solid layer 25 of quantum dots is formed on the layer of scintillator material 31.

At block 15 the first substrate 21 is provided overlaying a second substrate 27. The first substrate 21 may be provided overlaying the second substrate 27 so that the solid layer 25 of quantum dots is aligned with one or more of the electrical components on the second substrate 27.

In the example of Fig. 3 pressure is applied to the first substrate 21 as indicated by the arrows 29. This may ensure that that an electrical connection is made between the solid layer 25 of quantum dots and the electrical components on the second substrate 27. In the example of Fig. 3 this may also cause deformation of the scintillator material 31 so that at least some of the scintillator material 31 contacts the second substrate 27. This may enable the scintillator material 31 to be bonded or adhered to the second substrate 27. In some examples adhesive may be provided on the edges of the scintillator material 31and/or on the second substrate 27. The adhesive may be arranged to improve the coupling between the surface of the first substrate 21 and the scintillator material 31 or second substrate 27.

In the example method of Fig. 3 the first substrate 21 is removed from the second substrate 27 to form an apparatus 1 as indicated at block 17. In the example of Fig. 3 both the solid layer 25 of quantum dots and the scintillator material 31 are left on the second substrate 27.

As the solid layer 25 of quantum dots was formed on the scintillator material 31 this may ensure that a good optical connection is made between the solid layer 25 and the scintillator material 31. This may ensure that light emitted by the scintillator material 31 is efficiently directed onto the solid layer 25 of quantum dots. In some examples the scintillator material 31may provide the first substrate 21. This may reduce the number of components needed.

Fig. 4 schematically illustrates another example method in more detail. Corresponding reference numerals are used for corresponding features.

In the example method of Fig. 4 a first substrate 21 is provided at block 10. The first substrate 21 comprises an array of lenses 41.

The array of lenses 41 may comprise any means which may be configured to focus and direct light. The array of lenses 41 may be configured so that when the apparatus 1 is formed the array of lenses 41 focus and direct light onto the solid layer 25 of quantum dots.

In the example of Fig. 4 the array of lenses 41 are provided on a surface of the first substrate 21. At block 11 the quantum dot solution 23 is deposited on to the first substrate 21. The quantum dot solution 23 is deposited onto the array of lenses 41.

The quantum dot solution 23 may be deposited in any suitable pattern and using any suitable processes.

At block 13 the quantum dot solution 23 is solidified to form the solid layer 25 of quantum dots. The solid layer 25 of quantum dots is formed on the array of lenses 41.

At block 15 the first substrate 21 is provided overlaying a second substrate 27. The first substrate 21 may be provided overlaying the second substrate 27 so that the solid layer 25 of quantum dots is aligned with one or more of the electrical components on the second substrate 27.

In the example of Fig. 4 pressure is applied to the first substrate 21 as indicated by the arrows 29. This may ensure that an electrical connection is made between the solid layer 25 of quantum dots and the electrical components on the second substrate 27. In the example of Fig. 4 this may also cause deformation of the array of lenses 41 so that at least some of the array of lenses 41 contacts the second substrate 27. This may enable the array of lenses 41 to be bonded or adhered to the second substrate 27.

In the example method of Fig. 4 the first substrate 21 is removed from the second substrate 27 to form an apparatus 1 as indicated at block 17. In the example of Fig. 4 both the solid layer 25 of quantum dots and the array of lenses 41 are left on the second substrate 27. This may enable light to be collected by the array of lenses 41 and focused onto the solid layer 25 of quantum dots to provide an efficient optoelectronic apparatus 1. In some examples the array of lenses 41 may be arranged to overlap the solid layer of quantum dots 25. This may improve adhesion of the array of lenses 41 to the second substrate 27 and may increase the light collection efficiency.

In the example method of Fig. 4 an array of lenses 41 is used. It is to be appreciated that in other examples of the disclosure other types of optical components could be used instead. For instance the optical components could comprise light guides or any other suitable components.

In the examples of Figs. 3 and 4 the scintillator material 31 and the array of lenses 41 are provided on the first substrate 21 and then transferred from the first substrate 21 to the second substrate 27 so that the first substrate 21 can be removed and does not need to form part of the apparatus 1. In other examples the first substrate 21 is left on the second substrate 27 so that the first substrate 21 forms part of the apparatus 1. In such examples the scintillator material 31 or array of lenses 41 may be formed as an integral component of the first substrate 21.

The examples of Figs. 2 to 4 show single solid layers 25 of quantum dots being transferred using the first substrate 21. In other examples different sections of quantum dots could be printed onto the first substrate 21 so that different solid layers 25 are formed on different parts of the surface of the first substrate 21. This may enable multiple apparatus to be formed from a single deposition and transfer process. For example it may enable an array of transistors and/or light emitting diodes to be formed in a single process.

Fig. 5 schematically illustrates an example apparatus 1 according to examples of the disclosure. The apparatus may be formed using methods as described above.

The apparatus 1 comprises one or more electrical components 51 on a substrate 27 and a solid layer 25 of quantum dots electrically connected to the one or more electrical components 51. The solid layer 25 of quantum dots are printed onto a different substrate 21 and transferred onto the one or more electrical components 51 after the layer 25 of quantum dots has been solidified.

The electrical components 51 could comprise any suitable electrical components such as transistors, diodes or any other components. In some examples the electrical components could be formed on the substrate 27. The electrical components 51 could be provided on the surface of the substrate 27. In some examples one or more of the electrical components 51 could be embedded within the substrate 27.

In the example of Fig. 5 the substrate 27 which forms part of the apparatus 1 may be a second substrate 27 as described above. In some examples the apparatus 1 could also comprise a first substrate 21 and/or other components such as optical components 41 or scintillator material 31.

The apparatus 1 may be an optoelectronic apparatus 1 in which the solid layer 25 of quantum dots forms an optoelectronic layer within the apparatus 1. The optoelectronic layer could be configured to provide an electrical response in response to incident light and/or could be configured to provide light in response to an electrical input.

In some examples the apparatus 1 may be a nano-electronic apparatus. The nano-electronic apparatus 1 may comprise two dimensional material, such as graphene, which could be coupled to the quantum dots.

Figs. 6A and 6B illustrate another example apparatus 1. Fig. 6A shows the surface of a second substrate 27 after the solid layer 25 of quantum dots has been transferred to the second substrate 27. The solid layer 25 of quantum dots is formed in a pattern of predetermined shape. As the solid layer 25 of quantum dots forms a pattern the surface 61 of the second substrate 27 is left uncovered in some regions.

Fig. 6B shows a close up of the area highlighted by the square in Fig. 6A. In this region the solid layer 25 of quantum dots is provided overlaying electrical components 51. In the example of Fig. 6B the electrical components comprise GFET structures. Other electronic components could be used in other examples of the disclosure.

Examples of the disclosure provide improved methods for forming apparatus 1 comprising quantum dots.

Having the ligand exchange process and any other solidification processes carried out on the first substrate 21 may protect the second substrate 27 and any electrical components on the second substrate 27. As the processes are carried out on the first substrate 21 only the first substrate 21 is exposed to the chemicals used for the ligand exchange process or to any other parameters, such as UV light, that are used to solidify the quantum dots. This may enable the apparatus 1 to be formed without having to expose the second substrate 27 and any electrical components on the second substrate 27 to such parameters.

When the ligand exchange process is carried out the exchange occurs most effectively at the top surface of the quantum dot solution 23 as this is more exposed to the chemicals and solvents used for the ligand exchange process. This creates a higher proportion of short chain ligands at the top surface of the solid layer 25 of quantum dots. When the solid layer 25 of quantum dots is then arranged overlaying the second substrate 27 this provides a higher proportion of short chain ligands in the region of the solid layer 25 of quantum dots which contacts the electrical components on the second substrate 27. This may provide for an improved electrical connection between the solid layer 25 of quantum dots and the electrical components. In some examples this may provide for improved charge transfer between the solid layer 25 of quantum dots and the electrical components.

The use of the quantum dot solution may result in a uniform solid layer 25 of quantum dots. The uniform solid layer 25 of quantum dots may have a uniform thickness. This may provide a more reliable optoelectronics component.

In examples of the disclosure the quantum dot solution 23 may be deposited using any suitable process such as inkjet printing, aerosol jetting, microdispensing. These processes may enable a pattern of predetermined shape to be formed digitally. This may provide an efficient method of forming an apparatus 1 as it removes the need for any structuring of the first substrate 21. This may also provide more flexibility in the design of the patterns of quantum dots that can be formed. This may also reduce the amount of quantum dot solution that is wasted.

As the quantum dots are transferred to the second substrate 27 as a solid layer 25 this may reduce spreading of the quantum dots away from the electronic components 51. This ensures that the shape and clear edges of the deposited pattern are maintained.

The example methods may provide apparatus 1 with structured solid layers 25 of quantum dots with well defined edges. It may be possible to determine the process that has been used to form an apparatus 1 from the shapes and structures of the solid layers 25 of quantum dots.

In some examples the first substrate 21 may form an encapsulation layer 30 for the apparatus 1. This may provide an efficient method for forming an encapsulated apparatus 1 as no additional encapsulating processes are needed.

The term "comprise" is used in this document with an inclusive not an exclusive meaning. That is any reference to X comprising Y indicates that X may comprise only one Y or may comprise more than one Y. If it is intended to use "comprise" with an exclusive meaning then it will be made clear in the context by referring to "comprising only one..." or by using "consisting".

In this brief description, reference has been made to various examples. The description of features or functions in relation to an example indicates that those features or functions are present in that example. The use of the term "example" or "for example" or "may" in the text denotes, whether explicitly stated or not, that such features or functions are present in at least the described example, whether described as an example or not, and that they can be, but are not necessarily, present in some of or all other examples. Thus "example", "for example" or "may" refers to a particular instance in a class of examples. A property of the instance can be a property of only that instance or a property of the class or a property of a subclass of the class that includes some but not all of the instances in the class. It is therefore implicitly disclosed that a features described with reference to one example but not with reference to another example, can where possible be used in that other example but does not necessarily have to be used in that other example.

## Claims

1. A method comprising:
depositing (11) a quantum dot solution (23) onto a first substrate (21);
providing one or more electrical components on a second substrate (27), wherein the second substrate (27) is a silicon substrate,
solidifying (13) the quantum dot solution (23) on the first substrate (21) to form a solid layer of quantum dots (25);
arranging (15) the first substrate (21) overlaying the second substrate (27) so that an electrical connection is established between the solid layer of quantum dots (25) and the one or more electrical components on the second substrate (27), and
leaving (19) the first substrate (21) overlaying the second substrate (27), wherein the first substrate (21) forms an encapsulation layer configured to protect the solid layer of quantum dots (25) and the one or more electrical components.

2. A method as claimed in claim 1 wherein the quantum dot solution (23) is deposited onto optical components on the first substrate (21) and the optical components are transferred to the second substrate (27) when the electrical connection is established between the solid layer of quantum dots (25).

3. A method as claimed in claim 2 wherein the optical components comprise at least one of: a lens, a micro lens array, a waveguide, an anti-reflection layer.

4. A method as claimed in any preceding claim wherein the quantum dot solution (23) is deposited onto a scintillator material (31) on the first substrate (21) and the scintillator material is transferred to the second substrate (27) when the electrical connection is established between the solid layer of quantum dots (25).

5. A method as claimed in any preceding claim comprising performing a ligand exchange process on the quantum dot solution (23) on the first substrate (21) before the solid layer of quantum dots (25) is connected to the electrical components.

6. A method as claimed in any preceding claim wherein the quantum dot solution (23) is deposited via inkjet printing.

7. A method as claimed in any preceding claim wherein the first substrate comprises (21) an elastomer.

8. A method as claimed in any preceding claim wherein the electrical connection enables charge transfer between the quantum dots and the one or more electrical components on the second substrate (27).

9. A method as claimed in any preceding claim wherein the quantum dots are combined with other light sensitive materials.

## Patentansprüche

1. Verfahren umfassend:
Abscheiden (11) einer Quantenpunktlösung (23) auf ein erstes Substrat (21);
Bereitstellen eines oder mehrerer elektrischer Bauelemente auf einem zweiten Substrat (27), wobei das zweite Substrat (27) ein Siliziumsubstrat ist,
Verfestigen (13) der Quantenpunktlösung (23) auf dem ersten Substrat (21), um eine feste Schicht von Quantenpunkten (25) auszubilden;
Anordnen (15) des ersten Substrats (21) in Überlagerung des zweiten Substrats (27), so dass eine elektrische Verbindung zwischen der festen Schicht von Quantenpunkten (25) und dem einen oder den mehreren elektrischen Bauelementen auf dem zweiten Substrat (27) hergestellt wird, und
Belassen (19) des ersten Substrats (21) in Überlagerung des zweiten Substrats (27), wobei das erste Substrat (21) eine Kapselungsschicht ausbildet, die ausgelegt ist, die feste Schicht von Quantenpunkten (25) und das eine oder die mehreren elektrischen Bauelemente zu schützen.

2. Verfahren nach Anspruch 1, wobei die Quantenpunktlösung (23) auf optische Bauelemente auf dem ersten Substrat (21) abgeschieden wird und die optischen Bauelemente auf das zweite Substrat (27) übertragen werden, wenn die elektrische Verbindung zwischen der festen Schicht von Quantenpunkten (25) hergestellt wird.

3. Verfahren nach Anspruch 2, wobei die optischen Bauelemente mindestens eines der folgenden Elemente umfassen: eine Linse, ein Mikrolinsenarray, einen Wellenleiter, eine Antireflexionsschicht.

4. Verfahren nach einem vorhergehenden Anspruch, wobei die Quantenpunktlösung (23) auf ein Szintillatormaterial (31) auf dem ersten Substrat (21) abgeschieden wird und das Szintillatormaterial auf das zweite Substrat (27) übertragen wird, wenn die elektrische Verbindung zwischen der festen Schicht von Quantenpunkten (25) hergestellt wird.

5. Verfahren nach einem vorhergehenden Anspruch, umfassend: Durchführen eines Ligandenaustauschprozesses an der Quantenpunktlösung (23) auf dem ersten Substrat (21), bevor die feste Schicht von Quantenpunkten (25) mit den elektrischen Bauelementen verbunden wird.

6. Verfahren nach einem vorhergehenden Anspruch, wobei die Quantenpunktlösung (23) über Tintenstrahldruck abgeschieden wird.

7. Verfahren nach einem vorhergehenden Anspruch, wobei das erste Substrat (21) ein Elastomer umfasst.

8. Verfahren nach einem vorhergehenden Anspruch, wobei die elektrische Verbindung eine Ladungsübertragung zwischen den Quantenpunkten und dem einen oder den mehreren elektrischen Bauelementen auf dem zweiten Substrat (27) gestattet.

9. Verfahren nach einem vorhergehenden Anspruch, wobei die Quantenpunkte mit anderen lichtempfindlichen Materialien kombiniert werden.

## Revendications

1. Procédé comprenant les étapes consistant à :
déposer (11) une solution de boîtes quantiques (23) sur un premier substrat (21);
fournir un ou plusieurs composants électriques sur un deuxième substrat (27), ledit deuxième substrat (27) étant un substrat de silicium,
solidifier (13) la solution de boîtes quantiques (23) sur le premier substrat (21) pour former une couche solide de boîtes quantiques (25);
disposer (15) le premier substrat (21) recouvrant le deuxième substrat (27) de telle façon qu'une connexion électrique soit établie entre la couche solide de boîtes quantiques (25) et lesdits un ou plusieurs composants électriques sur le deuxième substrat (27), et
laisser (19) le premier substrat (21) recouvrant le deuxième substrat (27), ledit premier substrat (21) formant une couche d'encapsulation configurée pour protéger la couche solide de boîtes quantiques (25) et lesdits un ou plusieurs composants électriques.

2. Procédé selon la revendication 1, dans lequel la solution de boîtes quantiques (23) est déposée sur des composants optiques sur le premier substrat (21) et les composants optiques sont transférés vers le deuxième substrat (27) lorsque la connexion électrique est établie entre la couche solide de boîtes quantiques (25).

3. Procédé selon la revendication 2, dans lequel les composants optiques comprennent au moins l'un parmi une lentille, un réseau de microlentilles, un guide d'onde, une couche antiréflexion.

4. Procédé selon une revendication précédente quelconque, dans lequel la solution de boîtes quantiques (23) est déposée sur un matériau scintillateur (31) sur le premier substrat (21) et le matériau scintillateur est transféré vers le deuxième substrat (27) lorsque la connexion électrique est établie entre la couche solide de boîtes quantiques (25).

5. Procédé selon une revendication précédente quelconque, comprenant l'étape consistant à effectuer un processus d'échange de ligands sur la solution de boîtes quantiques (23) sur le premier substrat (21) avant que la couche solide de boîtes quantiques (25) soit connectée aux composants électriques.

6. Procédé selon une revendication précédente quelconque, dans lequel la solution de boîtes quantiques (23) est déposée via l'impression à jet d'encre.

7. Procédé selon une revendication précédente quelconque, dans lequel le premier substrat (21) comprend un élastomère.

8. Procédé selon une revendication précédente quelconque, dans lequel la connexion électrique autorise un transfert de charge entre les boîtes quantiques et lesdits un ou plusieurs composants électriques sur le deuxième substrat (27).

9. Procédé selon une revendication précédente quelconque, dans lequel les boîtes quantiques sont combinées avec d'autres matériaux photosensibles.
